(19)

Europäisches Patentamt

European Patent Office

Office européen des brevets

(11)     EP 2 587 518 B1

(12)         **EUROPEAN PATENT SPECIFICATION**

(45) Date of publication and mention
of the grant of the patent:
**19.12.2018  Bulletin 2018/51**

(51) Int Cl.:
**H01J 37/34** (2006.01)    **C23C 14/35** (2006.01)

(21) Application number: **11008717.8**

(22) Date of filing: **31.10.2011**

(54) **Apparatus and Method for depositing Hydrogen-free ta C Layers on Workpieces and Workpiece**

Vorrichtung und Verfahren zur Abscheidung wasserstofffreier ta-C-Schichten auf Werkstücken und Werkstück

Appareil et procédé de dépôt de couches ta C dépourvues d'hydrogène sur des pièces de travail et pièces

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**01.05.2013  Bulletin 2013/18**

(73) Proprietor: **IHI Hauzer Techno Coating B.V.
5928 LL Venlo (NL)**

(72) Inventors:
• **PAPA, Frank
5913 VK Venlo (NL)**
• **TIETEMA, Roel
5926 SK Venlo (NL)**
• **KOLEV, Ivan
6223 EC Maastricht (NL)**
• **JACOBS, Ruud
5912 XX Venlo (NL)**

(74) Representative: **Manitz Finsterwald Patentanwälte
PartmbB
Postfach 31 02 20
80102 München (DE)**

(56) References cited:
**EP-A2- 1 652 966     DE-U1-202010 001 497**

• LIN J ET AL: "Modulated pulse power sputtered chromium coatings", THIN SOLID FILMS, ELSEVIER-SEQUOIA S.A. LAUSANNE, CH, vol. 518, no. 5, 31 December 2009 (2009-12-31), pages 1566-1570, XP026764014, ISSN: 0040-6090, DOI: 10.1016/J.TSF.2009.09.118 [retrieved on 2009-10-06]
• JUNQI XU: "Hydrogen-free carbon thin films prepared by unbalanced magnetron sputtering", PROCEEDINGS OF SPIE, vol. 6149, 1 January 2006 (2006-01-01), pages 61492S-61492S-5, XP55018650, ISSN: 0277-786X, DOI: 10.1117/12.674295
• B M Dekoven: "Carbon Thin Film Deposition Using High Power Pulsed Magnetron Sputtering", SVC 46th Annual Conference Proceedings, 10 October 2003 (2003-10-10), pages 158-165, XP55018285, Retrieved from the Internet: URL:http://www.advanced-energy.com/upload/File/Reprints/Carbon Thin Film Deposition Using High Power.pdf [retrieved on 2012-02-02]

**Description**

The present invention relates to an apparatus and method for the manufacture of at least substantially hydrogen-free ta-C layers on substrates (workpieces) of metal or ceramic materials, and to a substrate having such a ta-C layer. Ta-C layers, also termed coatings, are defined in the VDI guideline 2840 entitled "Carbon Films, basic knowledge and film properties.

A paper entitled "Diamond-like Carbon Coatings for tribological applications on Automotive Components" by R. Tietema, D. Doerwald, R. Jacobs and T. Krug presented at the 4th World Tribology Congress, Kyoto, September 2009 discusses the manufacture of diamond-like carbon coatings from the beginning of the 1990's. As described there the first diamond-like carbon coatings (DLC-coatings) were introduced on the market for automotive components. These coatings enabled the development of HP diesel fuel injection technology.

The increasingly stringent environmental regulations applied around the world (for example Euro 4 and 5) promote the need to reduce friction in order to save fuel consumption and reduce $CO_2$ emissions. Suitable combinations of coatings, surface structure and lubricants have recently led to minimized friction. This is reported in investigations such as, in particular, those carried out by Kano. M, Yasuda, Y et al described in their paper Ultralow friction of DLC in presence of glycerol mono-oleate (GMO), Tribology Letters, Vol. 18, No. 2 (2005) 245. They have shown that a substantial decrease in friction is possible by using a suitable combination of oil and coating type, in particular the hydrogen free DLC-coating. For an a-C:H coating (hydrogenated DLC) on the steel surface the values for the coefficient of friction are 0.13 for a dry surface, 0.12 when a 5W30 lubricant is used and 0.9 when a lubricant comprising a mixture of PAO (i.e. Polyalphaole-finest and GMO (i.e. glycerol monooleate) is used. When a hydrogen-free ta-C DLC layer is used the comparative values are 0.13 for a dry surface, 0.09 for a surface lubricated with 5W30 engine oil but only just under 0.02 when a lubricant comprising a mixture of PAO and GMO is applied.

The German standard VDI 2840 ("Carbon films: Basic knowledge, film types and properties") provides a well-defined overview of the plurality in carbon films, which are all indicated as diamond or diamond-like coatings.

In this context the use of hydrogen-free ta-C coatings with appropriate lubricants is evidently very important. To date these coatings have been made using an arc process. A hardness in the range from 20GPa to 90GPa, in particular 43GPa to 80GPa; is considered useful (diamond has a hardness of 100Gpa). However, the coatings are quite rough because the arc process leads to the generation of droplets..The surface has rough points due to the droplets. Thus although low friction can be obtained the wear rate of the counterpart in the tribological system is relatively high due to the surface roughness caused by droplets.

The DE 20 2010 001 497 U1 discloses an apparatus for the manufacture of layers on substrates in accordance with the preamble of claim 1 of the present specification. The publication by X. Junqi et. al titled "Hydrogen-free carbon thin films prepared by unbalanced magnetron sputtering" published in the proceedings of SPIE Vol. 6149 (2006) 61492S-61492S-5, teaches a method to produce hydrogen-free carbon films with unbalanced magnetron sputtering. Further prior art is to be found in the publication by J. Lin et. al titled "Modulated pulse power sputtered chromium coatings", published in Thin Solid Films 518 (2009) 1566-1570, EP 1 652 966 A2 and the publication by B. M. Dekovenet. al titled "Carbon Thin Film Deposition Using High Power Pulsed Magnetron Sputtering" published in the SVC 46th Annual Conference Proceedings (2003), 158-165.

The object of the present invention is to provide an alternative apparatus and method by which (doped) hydrogen-free ta-C coatings with a hardness in the required range but with a relatively very smooth surface can be made which exhibit low wear (and lead to low wear of the sliding partner) and which can be deposited simply and relatively economically.

This object is satisfied by an apparatus in accordance with claim 1 and by means of a method in accordance with claim 13.

The pulse pattern consists of controllable macro-pulses of a length in the range of 10 to 5000 μsec, typically in the range between 50 and 3000 μsec, and especially between 400 and 800 μsec. The macro-pulses consist of controllable micro-pulses in the range from 1 to 100 μsec, typically 5-50 μsec. During each micro-pulse the power to the cathode is switched on and off. The range for switching on is typically between 2 and 25 μsec and the range for the power to be switched off is typically between 6 and 1000 μsec. Each micro-pulse generates an oscillation that is amplified to high values if the frequency of the pulses is appropriately selected, thus generating a highly ionized plasma. This power supply is further referred to as a HIPIMS+OSC power supply.

It has surprisingly been found that with an apparatus of this kind hydrogen-free (or at least substantially hydrogen-free) ta-C coatings with a hardness of 50GPa can readily be deposited on a metal or ceramic surface with a relatively smooth coating substantially free of droplets. Such coatings achieve low wear and a low friction of about 0.02 with the usual running partners such as valve train components (e.g. tappets), fuel injection components, engine components (e.g. piston rings) and power train components (e,g. gears). Also there is a high potential for using these coating on cutting and forming tools, especially for cutting materials where strong adhesive wear (BUE: Built-Up-Edge formation) is involved.

It can be advantageous to provide at least one other magnetron cathode, serving as a source of dopant material for the carbon based coating.

The bias power supply for applying a negative bias voltage to the substrate or substrates on the support device is preferably one of:

- a DC-supply (characterized by its capability to supply high current pulses whilst maintaining the bias voltage almost constant, i.e. within a range that is required for the supply of the necessary ion energy according to the teaching of the EP application 07724122.2 published as WO2007/115819,
- a pulsed DC supply (with capability to supply pulse currents whilst maintaining the bias voltage in the required range without switching off due to over current)
- or a RF-supply (with capability to supply pulse currents whilst maintaining the self-bias voltage in the required range without switching off due to over current). It is possible that a pulsed bias can be used as well as RF-bias.

The achievable deposition rate is relatively high, for example a 1 micron coating can be deposited (on a rotating substrate) within a period of about two to six hours using the following scheme for the example of non-doped ta-C:
The process is usually carried out at an Ar pressure of about 0.1 to 1.8Pa ($1 . 10^{-3} - 8.10^{-2}$mbar. It would be possible to use other inert, non-reactive gases so long as hydrogen is not present. The total process time depends largely on the maximum time averaged DC power with which the apparatus can be operated during coating. This typically lies in the range from 10 to 50kW but could be higher.

In the rest of this description, the expression "HIPMS" has to be read in general as HIPIMS, MPP or HIPIMS+OSC, unless otherwise specifically mentioned. When in the remainder of the description the word "pulse" is mentioned. It is to be interpreted as single pulse (in case of HIPIMS) or as a macro-pulse according to the description given above (in case of MPP or HIPIMS+OSC), unless something else has been specifically pointed out in the text.

The possibility exists of addition of doping elements in the coating. The addition of doping elements makes it possible to modify the tribological properties of the tribosystem part-lubricant-counterpart with respect to wear resistance improvement and friction reduction. In this connection it has been that, by adding silicon in hydrogenated PECVD produced DLC (a-C:H) in PECVD/sputtered carbon or carbon arc coatings, the wettability can be improved, therefore reducing friction. A small addition of hydrogen in sputtered carbon coatings will increase the hardness to levels exceeding the hardness of a-C:H coatings produced with PECVD. An addition of $N_2$ can also have beneficial influences. The addition of metals can be expected to improve the hardness of the coatings, or at least to make the coating better suitable for certain tribological wear phenomena, like for instance impact fatigue wear, high temperature wear, etc.

One possible coating process can be described as follow:
In a first step cleaning and etching of the substrate is carried out with Ar-ions, using an argon atmosphere in the vacuum chamber. This step is carried out for a period of 10 to 30 minutes
Another option for this step is the use of HIPIMS etching with a Cr, Ti or Si target operated in a HIPIMS magnetron etching mode with a relatively high substrate bias of - 500 to -2000V as well known in the art and described in EP-B-1260603 of Sheffield Hallam University. The typical time averaged equivalent DC etching power applied to the Cr, Ti or Si cathode is in the range of 1 to 25 kW.

In a second step a bond layer of Cr, Ti or Si is deposited on the metal or ceramic surface. This is done for about 10 to 20 minutes from a target of Cr, Ti or Si operated in a sputter discharge mode or in a HIPIMS coating mode. In this connection it should be noted that, in case of using a HIPIMS mode, the maximum average power which can be dissipated by and thus effectively applied to a cathode is the power which does not lead to an undesirable temperature increase of the cathode or unwanted melting thereof. Thus in a DC sputtering operation a maximum power according to the allowable thermal load of the target/cathode combination of approximately 15 W/cm$^2$ might be applied to a particular cathode. In HIPIMS operation a pulsed power supply is used which might typically apply power in 50 to 3000 $\mu$s wide pulses at a pulse repetition frequency of less than 1 Hz - 5 kHz. In an example: if the pulse is switched on during 20 $\mu$sec and a pulse frequency of 5 kHz is applied, each pulse would then have a power associated with it of 180kW resulting in an average power of

$$P = 180kW \times (20\mu s/(200-20)\mu s = 20kW$$

For this example the maximum pulse power that can be supplied during a HIPIMS pulse is thus 180kW.

According to the state of the art an appropriate substrate bias of about 0 to 200V should be provided. The deposition of the bond layer can also be done with filtered arc cathodes. Also the use of unfiltered arc cathodes is a possibility, but this is less advantageous because it will lead to additional roughness of the coating because of droplet generation.

In a third step a Cr C, Ti-C or Si-C transition layer is deposited for about 1 to 5 minutes with simultaneous operation of the Cr, Ti or Si and graphite targets in a HIPIMS+OSC mode or with carbon-arc cathodes with about -50 to -2000V substrate bias.

During deposition as little hydrogen containing gas as possible shall be used (an impurity due to an initial small amount of water vapour or the hydrogen containing contamination can never be completely precluded).

In a fourth step the ta-C hydrogen-free DLC coating is deposited using the graphite cathode operated with a HIPIMS+OSC power supply designed in accordance with the principal claim, i.e. using a cathode power supply which is connectable to the at least one graphite cathode and to an associated anode and which is designed as already described earlier.-During deposition the pulses sequences of the HIPIMS+OSC power supplies can be altered to change the coating properties and to enable a multilayered structure with alternating intermediate layers.

In this process the average power of the high power pulse sequences (macro-pulses) averaged over a longer period of time and each comprising a plurality of high power pulse sequences (micro-pulses) is comparable with the power of a DC sputtering system with a constant DC power in the range between 10 and 250 kW.

Moreover, the average power of the high power pulse sequences of the HIPIMS+OSC power supply in each micro-pulse in general exceeds the power of a HIPIMS pulse power which lies, for example, in the range between 100 and 1000 kW.

Thus the apparatus of the invention typically comprises a plurality of magnetrons and associated cathodes, at least one of which comprises a bond layer material (Cr, Ti or Si). The at least one cathode for the bond layer material can also be an arc cathode (filtered, or unfiltered). The apparatus further comprises a power supply for the sputtering of bond layer material for the deposition of the bond layer material on the substrate or substrates prior to deposition of the ta-C layer. A typical example of a bond layer material is as already stated Cr, Ti or Si. Thus there will usually be a minimum of two cathodes, typically one of Cr and one of graphite. In practice it may be more convenient to use a sputtering apparatus with four or more cathodes. This makes it relatively easy to arrange the magnetrons and/or the arc cathodes so that there is an alternating pole arrangement of N, S, N; (magnetron 1) S, N, S (magnetron 2); N, S, N (magnetron 3) and S, N, S (magnetron 4) arranged around the periphery of the vacuum chamber in manner known per se to ensure stronger magnetic confinement of the plasma (closed field).

It is also possible for the apparatus to have at least one arc cathode of graphite and also an apparatus for the generation of an arc for the deposition of an arc carbon layer on the bond layer from the at least one arc cathode of graphite before depositing the ta-C layer by magnetron sputtering from a graphite cathode..

The substrates typically consist of one of the following materials:
Steel, especially 100 Cr6, titanium, titanium alloys, aluminium alloys and ceramic materials such as WC. Other materials can be possible as well. Optionally nonconductive substrate materials can be used if RF-biasing or unipolar pulsed biasing is applied. In general the setup is preferable for components and tools to be coated, which require abrasive wear resistance, impact fatigue resistance and corrosion resistance.

For the expiry phase of each high frequency pulse sequence (macro-pulse), it is possible for the HIPIMS+OSC high frequency pulse source to be designed to supply unipolar power pulses (macro-pulses) with a lower pulse repetition frequency than the pulse repetition frequency of the high frequency pulses (micro-pulses) contained in the macro-pulse. This reflects the fact that less energy is then required to maintain he very high degree of ionization in the chamber at the end of each high power pulse sequence, thus leading to less heat which needs to be dissipated and reducing the working temperature of the graphite cathode(s).

The HIPIMS+OSC power supply expediently contains a capacitor that can be charged to supply the high frequency power pulses and also an LC oscillating circuit which is connected or connectable between the capacitor and the cathode or cathodes.

The cathode power supply preferably comprises an electronic switch controllable by a program and adapted to connect the capacitor to the at least one cathode at the pulse sequence repetition frequency for the generation of the desired pulse sequence.

The electronic switch or an additional electronic switch can be adapted to connect the capacitor after the build-up phase to the at least one cathode via the LC circuit to generate the high frequency DC power pulse at the desired pulse repetition frequency for the high power DC pulses of each pulse sequence.

Thus, an LC oscillating circuit is usefully provided for the generation of the high frequency DC pulse component of the pulse sequence. It may seem a little strange that an LC oscillating circuit is used to generate a DC pulse component. It appears however that the apparatus has an inherent rectifying function leading to the DC pulses.

The invention also comprises the use of dopants to the ta-C coating. In this respect dopants can be metals from sputter targets operated with arc, sputter or HIPIMS cathodes (Si, Cr, Ti, W, WC) or dopants which are supplied from the precursors in gas phase (hydrocarbon gases, nitrogen, oxygen, Si containing precursors like silane, HMDSO, TMS).

The invention also relates to a substrate having a ta-C layer which is made by the method of one of the present claims.

The invention will now be explained in more detail with reference to the accompanying drawings in which are shown:

Fig. 1            a schematic view of a cathode sputtering apparatus for depositing ta-C coatings,

Fig. 2            a cross-section through a modified version of the vacuum chamber of the apparatus of Fig. 1,

Fig. 3            a schematic view of a cathode power supply for use in the apparatus of Fig. 1 or 2,

Figs. 4A-4C      schematic diagram of the high power DC pulse sequences used to investigate the manufacture of the ta-C coating by magnetron sputtering,

Fig. 5A           a bar graph showing hardness as a function of various parameters as recited in Table 2, and

Fig. 5B           a bar graph showing hardness as a function of various parameters as recited in Table 3.

In all drawings the same reference numerals have been used for the same components or features or for components having the same function and the description given for any particular component will not be repeated unnecessarily unless there is some distinction of importance. Thus a description given once for a particular component or feature will apply to any other component given the same reference numeral.

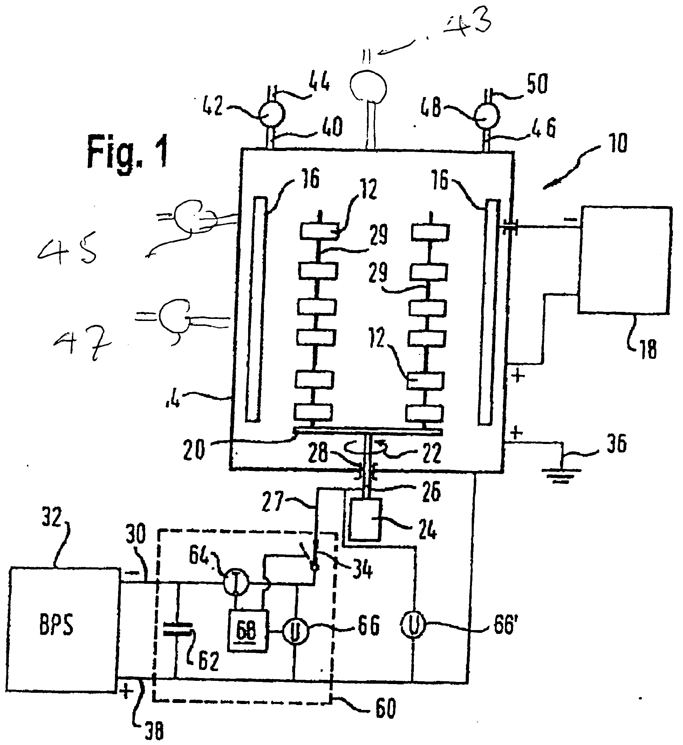

Referring first to Fig. 1 a vacuum coating apparatus is 10 is shown for coating a plurality of substrates or workpieces 12. The apparatus includes a vacuum chamber 14 of metal, which in this example has two oppositely disposed magnetron cathodes 16 which are each provided with a high power impulse power supply 18 (of which only one is shown here) for the purpose of generating ions of a material which is present in the gas phase in the chamber 14, i.e. inert gas ions and/or ions of the materials of which the respective cathodes are formed. The workpieces 12 are mounted on a support device in the form of a table 20 which rotates in the direction of the arrow 22 by means of an electric motor 24. The electric motor drives a shaft 26 which is connected to the table 20. The shaft 26 passes through a lead-through 28 at the base of the chamber 14 in a sealed and isolated manner which is well known per se. This permits one terminal 30 of the bias power supply 32 to be connected via a lead 27 to the workpiece support 20 and thus to the workpieces. This substrate bias power supply 32 is shown here with the letters BPS an abbreviation for bias power supply. The BPS is preferably equipped with HIPIMS-biasing capability, as described in the EP application 07724122.2 published as WO2007/115819, in particular with regard to the embodiment of Figs. 1 to 3.

Biasing can also be done by pulsed biasing or RF-biasing. Pulsed biasing can be synchronized with the HIPIMS-cathode pulses (also described in WO2007/115819). Good results can be achieved with the HIPIMS-DC biasing described in connection with Figs. 1 to 3 of WO2007/115819. For thicker coatings, HIPIMS biasing may be an issue because of more or less non-conductivity of the coating.

In this example the metallic housing of the vacuum chamber 14 is connected to ground and this is at the same time the positive terminal of the apparatus. The positive terminal(s) of the high impulse cathode power supply(ies) 18 is/are likewise connected to the housing 14 and thus to ground 36 as well as the positive terminal of the bias power supply 32.

A connection stub 40 is provided at the top of the vacuum chamber 14 (but could be at located at other locations as well) and can be connected via a valve 42 and a further line 44 to a vacuum system for the purpose of evacuating the treatment chamber 14. The vacuum system is not shown but well known in this field. A further line 50, which serves for the supply of an inert gas, especially argon to the vacuum chamber 14, is likewise connected to the top of the vacuum chamber14 via a valve 48 and a further connection stub 46. For dopants, additional gas supply systems 43, 45, 47 can be used.

Vacuum coating apparatus of the generally described kind are known in the prior art and frequently equipped with two or more cathodes 16. For example a vacuum coating apparatus is available from the company Hauzer Techno Coating BV in which the chamber has a generally square shape in cross-section with one cathode at each of the four sides. This design has one side designed as a door permitting access to the chamber 14. In another design the chamber is approximately octagonal in cross-section with two doors which each form three sides of the chamber. Each door can carry up to three magnetrons and associated cathodes 16. A typical vacuum coating apparatus includes a plurality of further devices which are not shown in the schematic drawings of this application. Such further devices comprise items such as dark space shields, heaters for the preheating of the substrates and sometimes electron beam sources or plasma sources in diverse designs. Finally, it is also possible to provide arc cathodes with respective arc power supplies in the same chamber in addition to magnetron cathodes. When using the apparatus air is first extracted from the vacuum chamber 14 by the vacuum pumping system via the line 44, the valve 42 and the line 40 and the argon is supplied via the line 50, the valve48 and the connection stub 50. The chamber and the workpieces are preheated during pump-down to drive out any volatile gases or compounds which adhere to the workpieces or chamber walls.

The inert gas (argon) which is supplied to the chamber is always ionized to an initial extent, for example by cosmic radiation and splits up into ions and electrons.

By generating a sufficiently high voltage on the workpieces, a glow discharge can be generated on the workpieces. The argon ions are attracted to the workpieces and collide there with the material of the workpieces, thus etching the workpieces.

Alternatively, Ar ions can be generated by a plasma source. The generated ions can be attracted to the workpieces by a negative substrate bias voltage and can then etch the workpieces.

As soon as the etching treatment has been carried out the coating mode can be switched on. For a sputter discharge, during deposition the cathodes will be activated. Ar-ions are colliding with the target and knock atoms out of the target. Electrons are ejected from the target due to sputtering and are accelerated by the dark space voltage gradient. With their energy they can collide with Ar atoms, where secondary electrons will be emitted and help to maintain the discharge. Each of the cathodes is provided with a magnet system (not shown in Fig. 1 which is well known per se and which normally generates a magnetic tunnel in the form of a closed loop which extends over the surface of the associated cathode. This tunnel formed as a closed loop forces the electrons to move around the loop and collide with argon atoms causing further ionization in the gas atmosphere of the vacuum chamber 14. This in turn causes further ionization in the chamber from the material of the associated cathode and the generation of further argon ions. During deposition these ions can be attracted to the substrates by the applied negative bias voltage of for example 120 V to 1200 V and strike the surface of the workpieces with appropriate energy to control the coating properties.

In case of a HIPIMS discharge, a different discharge mode is effective. The number of ions increases dramatically and as a consequence the target material particles knocked out from the target will be ionized. This is not the case for a normal sputter discharge. As a consequence gases present in the chamber will be highly ionized as well. This is beneficial when dopants are applied.

The power supply to the cathode or cathodes causes a flux of ions of the material of the cathode to move into the space occupied by the workpieces 12 and to coat them with the material of the respective cathode. The structure of the coating is influenced by the applied negative bias voltage that influences the movement of ions towards the workpieces.

Sputtering processes are known in diverse forms. There are those that operate with a constant voltage at the cathodes and a constant negative voltage at the workpieces and this is termed DC magnetron sputtering. Pulsed DC sputtering is likewise known in which at least one of the cathodes is operated in a pulsed mode, i.e. pulsed power is applied to the cathode by a pulsed power supply.

A special form of a pulsed discharge is the HIPIMS discharge. In a HIPIMS mode the power which is supplied to each cathode during a power impulse can be much higher than the power of a DC sputtering mode because there are substantial intervals between each pulse and the average power remains the same as for DC puttering. The limiting constraint on the power is the amount of heat that can be dissipated at the cathode before this overheats.

In recent times the cathodes are no longer supplied with a constant power but rather with power impulses of much higher power but only in relatively short pulses. This leads to a higher ionization in the vacuum chamber and improved coatings. For example, in well known HIPIMS sputtering (high power impulse magnetron sputtering), each power pulse can have a duration of say 10 $\mu$s and a pulse repetition time is used of say 200 $\mu$s, (corresponding to a pulse repetition frequency of 5000 Hz, i.e. a spacing between impulses of 190 $\mu$s). These values are only given as an example and can be varied in wide limits. For example, an impulse duration can be selected between 10 $\mu$s and 4 ms and a pulse repetition time between 200 $\mu$s and 1 s. As the time during which a very high peak power is applied to the cathodes is short the average power can be kept to a moderate level equivalent to that of a DC sputtering process. It has however been found that by the application of high power impulses at the cathode these operate in a different mode in which a very high degree of ionization of the ions arises which are ejected from the cathodes, with this degree of ionization, which is material dependent, lying in the range between 40% and indeed up to 90%. As a result of this high degree of ionization, many more ions are attracted by the workpieces and arrive there with higher velocities which lead to denser coatings and make it possible to achieve completely different and better coating properties then regular sputtering or arc coating.

The fact that the power is supplied in power peaks means however that relatively high currents flow in the bias power supply during these power peaks and the current take up cannot be readily supplied by a normal power supply.

In order to overcome this difficulty WO 2007/115819 describes a solution as shown in Fig. 1 of this application in which an additional voltage source 60 is provided which is best realized by a capacitor. The capacitor 60 is charged by a customary bias power supply to the desired output voltage. When a power impulse arrives at one of the cathodes from the HIPIMS power supply 18 then this leads to an increased material flow of ions, essentially ions of the cathode material to the workpieces 12 and this signifies an increase of the bias current at the bias power supply via the workpiece support 20 and the line 27. A normal bias power supply could not deliver such a peak current when it is designed for constant DC operation instead of HIPIMS operation. However, the capacitor 62, which is charged by the bias power supply to the desired voltage in the periods between the power impulses, is able to keep the desired bias at the substrates constant within narrow limits and to supply the required current which only cases a small degree of discharging of the capacitor. In this way, the bias voltage remains at least substantially constant.

By way of example the discharge can take place in such a way that a bias of -50V drops during the power pulses to -40V.

As HIPIMS sputtering has developed there have been some proposals to use special high power pulse sequences instead of single power pulses. In accordance with the present invention it has surprisingly been found that with HIPIMS+OSC power supplies excellent hydrogen-free ta-C coatings can be formed from a graphite cathode when such pulse sequences are used with parameters in particular ranges.

In the simplest form of the present invention one of the cathodes 16 is a graphite cathode for supplying the carbon by magnetron sputtering and the other is a Cr, Ti or Si target for supplying a bond layer material. Possibly, other materials could also be used for a bond layer.

All the depositions of ta-C layers investigated were performed using workpieces on a table 20 of 850 mm diameter. To ensure good adhesion of the hard hydrogen-free carbon layer on the substrate, the apparatus initially used a standard ARC adhesion layer such as is used when depositing ta-C by carbon arc. It will not be described in detail because it is not the preferred solution and the arc process is in any case well known.

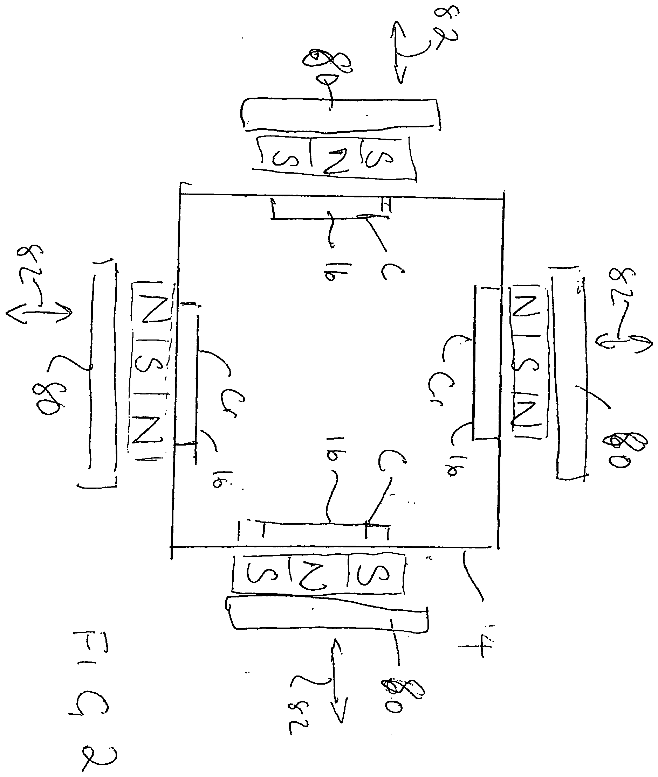

Fig. 2 shows a view of the vacuum chamber of Fig. 1 in a cross-section perpendicular to the vertical axis with additional detail but without the workpieces. The chamber also has four cathodes, two of Cr as a bond layer material and two of graphite for forming the ta-C layer.

The two cathodes 16 labelled also C are of graphite and have magnet arrangements with centre poles of polarity "north" (N) and outside poles of polarity "south" (S) to generate the well known magnetic tunnel of a magnetron. The cathodes have the shape of elongate rectangles when viewed face on and are shown here in a cross-section perpendicular to their long axis. Instead of having SNS polarity as shown, they could have NSN polarity as shown for the magnet arrangements for the Cr cathodes at the top and bottom of Fig. 2. The CR cathodes 16 would then have magnet arrangements with SNS polarity.

The magnet arrangements can be moved in the direction of the respective double arrows 82 towards and away from the respective cathodes 16. This is an important control parameter for the operation of the HIPIMS cathodes.

The idea is for the magnetrons to have alternating polarities going around the vacuum chamber 14. This means, with an even number of cathodes that the magnetic poles always alternate, i.e. N, S, N, S, N, S, N, S, N, S, N, S, when going around the chamber. This leads to an enhanced magnetic confinement of the plasma. A similar magnetic confinement can also be achieved if all cathodes have the same polarities, say NSN. Then it is necessary to operate with auxiliary S poles between the adjacent magnetrons to obtain a similar N, S, N, S, N arrangement around the chamber. It will be appreciated that the described arrangements only work with an even number of magnetrons. However, it is also possible to obtain a similar effect with an odd number of magnetrons either by making some poles stronger than others or by the use of auxiliary poles. Such designs to obtain a closed plasma are well known and documented in various patent applications.

What Fig. 2 also shows is four rectangular coils 81 positioned like the magnets with the SNS poles or NSN poles outside of the chamber 14. The coils form electromagnets and have the same polarity as the outer magnets for the respective cathodes 16. These electromagnetic coils 81 enable the magnetic flux in front of the cathodes 16 and inside the chamber 14, to be varied.

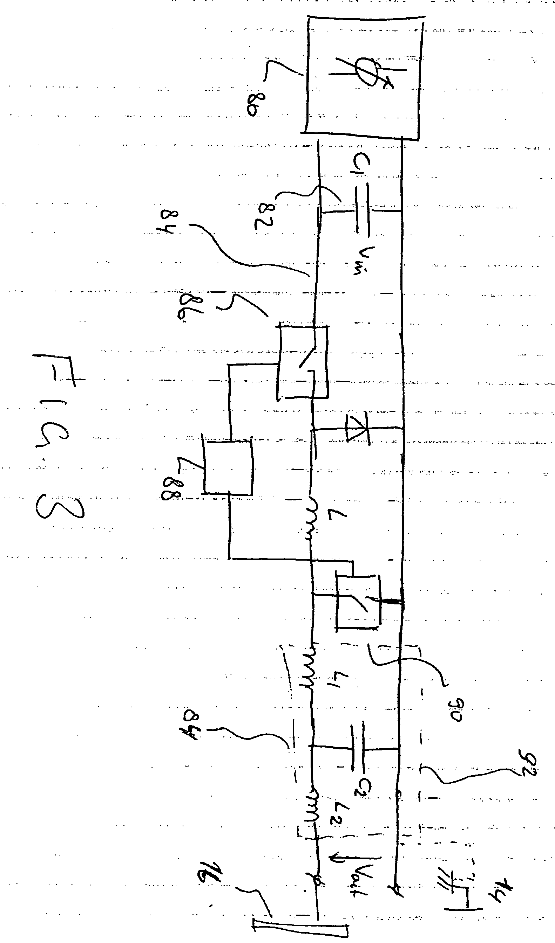

Fig. 3 shows the principle circuit for a special HIPIMS+OSC cathode power supply 18. It has a source 80 of constant voltage Vin (which can be varied) which is connected across a capacitor 82. A lead 84 goes from the negative terminal of the source of constant power 80 and of the capacitor 82 to the respective cathode 16. A second lead 85 goes from the positive terminal of the source of constant power 80 to the anode. In most cases the anode will be the grounded wall of the vacuum chamber 14. An additional anode is sometimes provided in the vacuum chamber 14 adjacent to the cathode 16 and can be advantageous. The reference numeral 86 designates an electronically controllable switch with a programmable electronic control 88. The electronic control 88 can be controlled by various programs called pulse files to vary the parameters of the pulse sequences provided for each high power pulse sequence by opening and closing the electronic switch 86, which can for example be an IBGT or similar device. It is to be noted that switch 86 plays a role in the extinguishing of an (undesired) arc discharge on the cathode. Also it is to be noted that the equipment allows for a combination as well as a separation of the voltage control switches. It is for example possible that the controls for the voltage Vin on capacitor 82 can be used for the control of the output voltage according to the macro-pulse programming, which of course also needs to be switched off immediately in case of arc detection. Therefore it should be noted that the switch is drawn as a functional device, which can correspond to one or more distributed components in the actual device.

The electronic control 88, which can be thought of as a microprocessor or microcontroller, is also able to operate a further electronic switch 90. This switch is used as a crowbar, which together with switch 86 will be switched on if an arc occurs on the cathode. This switch will preferentially be connected directly between the output terminals of cathode and anode (14 and 16) in order to dissipate as much stored energy from capacitors and inductances as possible for fastest switching off.

An LC circuit 92 is connected into the lead 84 so that the power applied during each high power pulse sequence can be modified at the resonant frequency of the LC circuit, which is preferably also a tunable LC circuit capable of operating at various resonant frequencies.

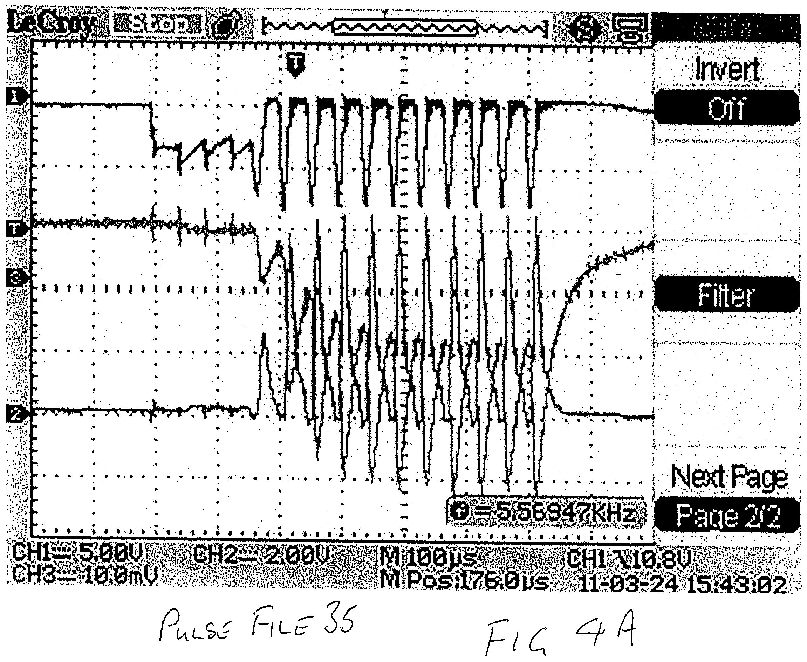

It should be noted that for reasons which are not well understood the plasma in side the vacuum chamber acts as complicated electrical load with non-linear characteristics which lead to the waveforms explained below with reference to Figs. 4A to 4C. It has been found that by increasing the frequency resonant conditions can be created, leading to high oscillations of current and power. Hence, the oscillating voltage after the initial build up phase of each high power pulse sequence is an oscillating unipolar voltage which does not alternate from positive to negative polarity but always has the same negative DC polarity, albeit of an oscillating nature.

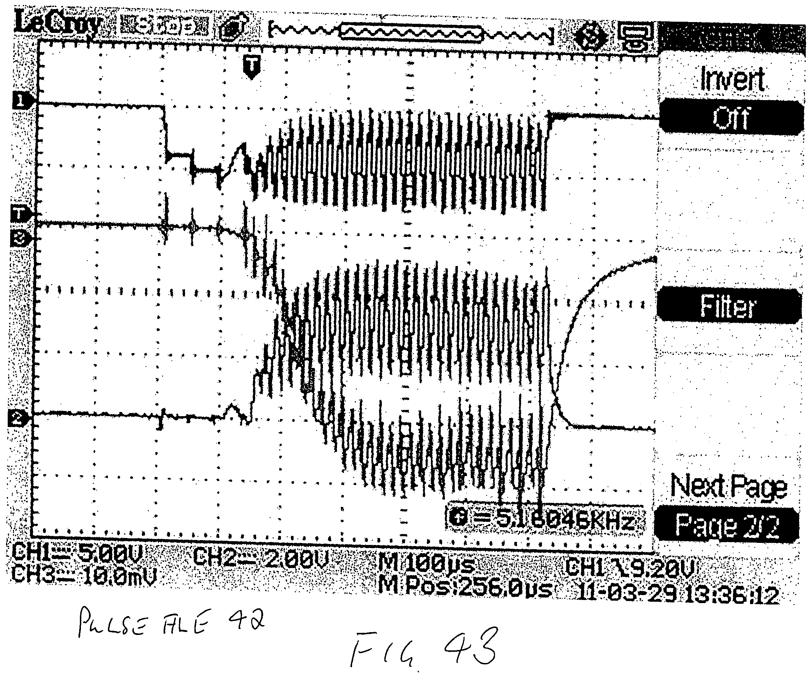

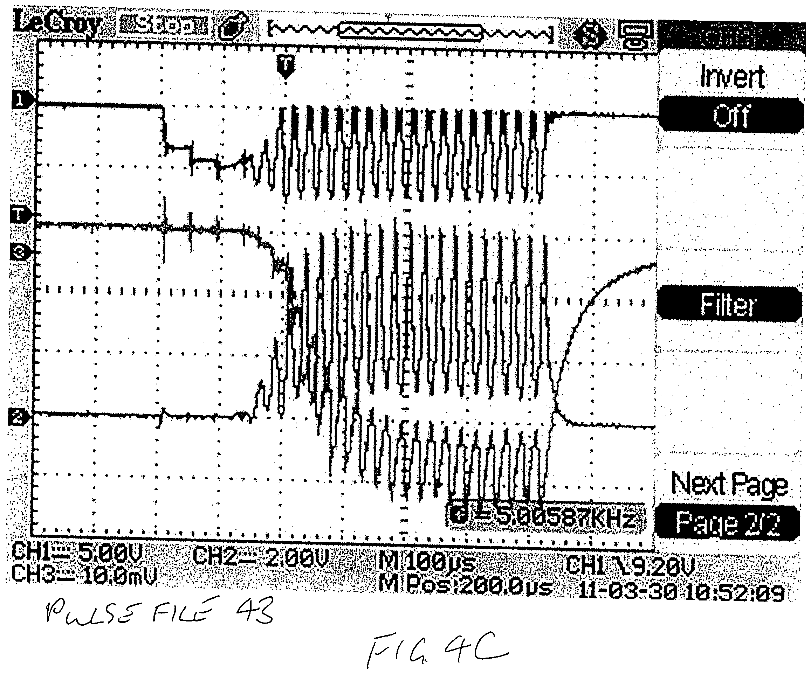

The most characteristic properties from a process point of view of the pulse unit used here, as described in connection with Fig. 3 is that a wide range of possible pulse shapes can be generated. The pulse unit described allows variations of the off times, such as long off times of the voltage pulses within a pulse package, i.e. within one high frequency pulse sequence (macro-pulse). Due to the long off time of the voltage the cathode current also returns to zero. This is illustrated in the oscilloscope trace of the Fig. 4 recordings shown below. Three different pulse files are shown of which the characteristics are given in Table I below.

In Table 1 some parameters are given that have been applied for the respective pulse file (column 1 in Table 1). Pulse files are the programs for the macro-pulses. In this example the macro-pulses have been built up from micro-pulses in a here called ignition part (column 2-6) and a here called highly ionized part (column 11). In column 12 is the total time of the macro-pulse mentioned. Details about the columns of table 1 are explained by the first line: the pulse file concerned here is named 35. In the ignition part of the macro-pulse, 4 repetitive pulse cycles have been programmed (column 5), where each individual cycle consists of a micro-pulse. For each micro-pulse the voltage is switched by means of switch 86 to the output for 3 μs (voltage on) followed by a period of 40 μs in which the voltage is switched off. This on/off cycle is repeated 4 times (column 5), which leads to a duration (column 2) of 172 μs (4x40+4x3). The frequency of 23 kHz indicated in column 6 is derived from the periodicity of 43 μs, determined by the sum of column 3 and 4.

After the ignition period, a highly ionized period follows. Here the micro-pulse consists of 30 μsec off (column 8) and 14 μsec on (column 9).The period of this micro-pulse is therefore 44 μsec, corresponding to 22.7 kHz (column 11). The number of micro-pulses programmed in the highly ionized part, is 11 (column 10), resulting in a duration of the highly ionized period of 484 μsec (column 8, calculated from columns 10 and the sum of column 8 and 9). The total duration of the macro-pulse in column 12 is 656 μsec, which is calculated from the sum of all micro-pulse periods. In this case it is the sum of the durations of the ignition period (column 2) and of the highly ionized period (column 7).

TABLE 1

| Col. 1 | Col.2 | Col.3 | Col.4 | Col. 5 | Col.6 | Col.7 | Col.8 | Col.9 | Col. 10 | Col.11 | Col. 12 |
|---|---|---|---|---|---|---|---|---|---|---|---|
| pulse file | t_ign (μs) | t_ign_ off | t_ign_ on | #_ ign | f_ign (Hz) | t_H1 (μs) | t_H1_ off | t_H1_ on | #_ H1 | f_H1 (Hz) | t_ pulse (μs) |
| 35 | 172 | 40 | 3 | 4 | 23256 | 484 | 30 | 14 | 11 | 22727 | 656 |
| 42 | 172 | 40 | 3 | 4 | 23256 | 480 | 6 | 10 | 30 | 62500 | 652 |
| 43 | 172 | 40 | | 4 | 23256 | 480 | 10 | 14 | 20 | 41667 | 652 |

Every pulse starts with an ignition pulse. After the ignition pulse, pulse file 35 generates pulses with long off times, while pulse file 42 generates pulses with short off times. Pulse file 43 has intermediate off times. This can also be seen in the oscilloscope recordings of Figs 4A to 4C.

For pulse file 35 the cathode current has the largest oscillations and it actually drops down to zero. It is noteworthy that the bias current also has the largest oscillations, as can be expected, but the off time is still not large enough for the bias current to drop down back to zero.

In Fig. 4A-4C the displayed signals are the cathode voltage, the topmost trace which is labelled 1 at the left hand side, the bias current which is the trace that starts at the left hand side in the middle at approximately the level labelled T and drops to the lowest position, and the cathode current which starts at the lowest position at the left hand side labelled 2 and rises to the middle position. This description of the traces can most easily be followed in Figs.4B and 4C and then read over into Fig. 4A. The scaling in the oscillogram is 100μsec/DIV for the (horizontal) time scale, whereas for the vertical scale for the signals is set to 160 Amps/DIV for cathode current, 10 Amps/DIV for the bias current, and 700 Volt/DIV for the cathode voltage. DIV is used here as an abbreviation for Division" and one DIV gives the height of one of the boxes subdivided into five smaller graduations It should be noted that the level labelled 1 corresponds to zero volts. The value labelled T is actually the zero level for the bias current (i.e. there is an offset from the value labelled T to the start of the curve for the bias current of a few amps which can be calculated from the scale of the graphs). The position labelled 2 is the zero value for the cathode current.

In the enlarged oscillogram of Fig. 4A the parameter setting of the pulse files according table 1 is recognizable. As an example: the trace for the cathode current in Fig. 4A shows that the ignition part lasts 172 μsec, whereas counting of the last 2 divisions of the highly ionized part contains somewhat less then 5 cycles. In the latter case 5 cycles would last 220 μsec according to Table 1, column 8 and 9.

Process parameters: pulse file and magnetic field

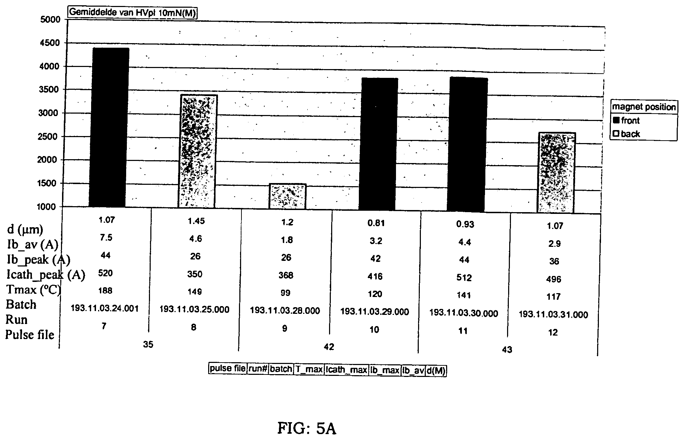

In order to scan the process window the three shown pulse files were used to deposit hydrogen-free carbon layers. In addition the magnetic field was changed by putting the magnetic board, i.e. the holder of the permanent magnets, either in the front or back position, as symbolised by the arrow 82. In the front position the horizontal field strength (parallel to the carbon target surface) is approximately 600 Gauss. The back position results in a magnetic field strength of approximately 300 Gauss. One of the most interesting properties of the coating is the hardness. In Table 2 below the hardness result of the 6 deposited coatings (3 pulse files x 2 magnetic field strengths) is shown. The results are also shown in the bar graph of Fig. 5A. Other characteristic process parameters (maximum temperature, peak cathode current, peak bias current, average bias current) and the coating thickness are also given. All depositions ran for 12 hours, unless otherwise indicated.

| Run number | Pulse File | Pulse length (μs) | Magnet position | Max. temp. in °C | Avg. Bias current | Max Ibias current | Max cath. current | Thickness in μm | Hardness HVpl 10mN |
|---|---|---|---|---|---|---|---|---|---|
| 7 | 35 | 656 | front | 188 | 7,5 | 44 | 520 | 1,07 | 4394 |
| 8 | 35 | 656 | back | 149 | 4,6 | 26 | 350 | 1,45 | 3417 |
| 9 | 42 | 652 | back | 99 | 1,8 | 26 | 368 | 1,2 | 1546 |
| 10 | 42 | 652 | front | 120 | 3,2 | 42 | 416 | 0,81 | 3812 |
| 11 | 43 | 652 | front | 141 | 4,4 | 44 | 512 | 0,93 | 3851 |
| 12 | 43 | 652 | back | 117 | 2,9 | 36 | 496 | 1,07 | 2727 |

### Table 2: Hardness as a function of several parameters

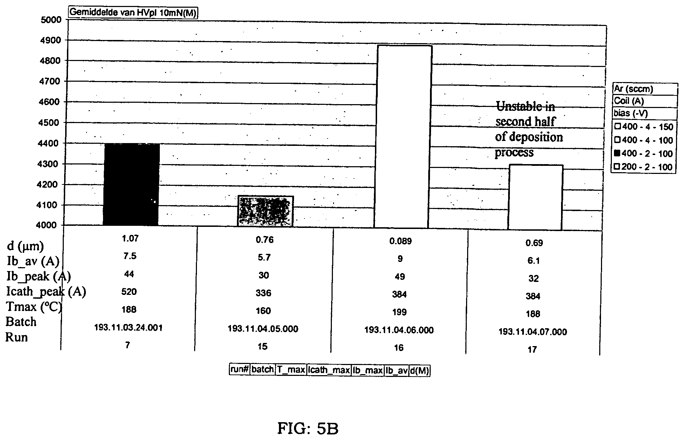

TABLE 2 in indicated as a table above and as a bar graph in Fig. 5. The most important conclusion to be drawn from this table is that pulse files with the longest off-time in the high ionization part (all pulse files had the same ignition part) gave the hardest coating (pulse file 35), whereas shorter off times result in softer coatings (pulse file 42 with shortest off time gives softest coating).

A stronger magnetic field results in a harder coating. For each individual pulse file this correlates with the peak bias current and the peak cathode current. It should be noted however that for different pulse files this correlation is lost. For example, pulse file 35 with magnets in back position has a peak bias current of 26 A and a coating hardness of 3400 Vickers, and pulse file 43 with magnets in back position has a peak bias current of 36 A and a hardness of only 2700 Vickers. This is possibly caused by the peak cathode current. It is known that the height of the peak cathode current is one of the dominating parameters for the ionization of the cathode material. The increase in bias current is probably related to an additional ionization of Ar gas.

From this first scan of parameters it is concluded that the best result can be obtained with the strongest magnetic field (magnets in front) and the longest off time in the pulse package (pulse file 35).

Process parameters: argon flow. UBM coil current, and bias voltage

Other process parameters which can influence the coating properties are the maximum temperature, the process pressure, the UBM coil current, and the bias voltage. To investigate the effect these parameters have on the coating properties, the coating of run 7 (pulse file 35, magnets in front, 400 sccm Ar, 2 A UBM coil current, 100 V bias) was taken as the reference.

The effect on the coating hardness of these parameters is shown in Table 3 below and illustrated also in the bar graph of Fig. 5B.

| run # | Ar (sc cm) | Coil (A) | Bias Volt. | pulse file | Pressure in $10^{-3}$ mbar | Max. Temp.in °C | Average bias curent | Max. bias current | Max. cath. current | Avg. Power in kW | Thickne ss in μm | HVpl 10mN |
|---|---|---|---|---|---|---|---|---|---|---|---|---|
| 7 | 400 | 2 | 100 | 35 | 2,47 | 188 | 7,5 | 44 | 520 | 9 | 1,07 | 4394 |
| 16 | 400 | 4 | 100 | 35 | 2,53 | 199 | 9 | 49 | 384 | 7 | 0,089 | 4890 |
| 17 | 400 | 4 | 150 | 35 | 2,48 | 188 | 6,1 | 32 | 384 | 7 | 0,69 | 4319 |

TABLE 3. Influence of variation of pressure (by Ar flow), coil current and bias voltage.

Increasing the coil current from 2 A to 4 A (which increases the ionization because of the stronger unbalancing effect on the cathodes) has a positive effect on the coating hardness. Also the peak bias current, and therefore the coating temperature, goes up in this case. Under these conditions a coating hardness of almost 4900 Vickers was achieved, which is the best result obtained so far. Further investigations have to be done and will probably add more information to these coatings.

Probably it makes no sense to increase the bias voltage combined with increased coil currents. It is likely that there is an optimum for the combination off higher coil currents and higher bias voltages. The optimum is in this case probably lower than 150 V.

Summary and recommendations

From the current scan of the process parameters it can be concluded that the best result is obtained by depositing with long off times of the voltage pulses within the pulse package or sequence. Depositing with higher UBM coil currents results in the deposition of a hydrogen-free carbon coating with the highest measured hardness so far (almost 4900 Vickers). Thus, the following recommendations can be given:

- Use higher UBM coil current (e.g. 6 A)
- Use a lower negative bias voltage
- Find an optimum for the combination of coil current and bias voltage.
- Also it is conceivable that adding small amounts of C2H2 and thus permitting a small proportion of hydrogen in the coating (less than about 1%) could be beneficial.
- Introduction of other dopants could be beneficial for the tribological properties, even though it does not necessarily lead to a higher hardness.

When an optimum coating from this parameter window has been obtained then attention should be paid to the base layer or bond layer. It seems that improvements can be made by:

- Replacing the carbon arc ion etch by a HIPIMS carbon ion etch or by other bond layers produced by regular sputtering.
- Deposition of the hard hydrogen-free carbon layer on top of a (standard) DLC coating could be beneficial for tribological systems, but also for other wear systems as referred to above.

**Claims**

1. Apparatus (10) for the manufacture of carbon layers on substrates of metal or ceramic materials, wherein the apparatus includes at least the following components:

   a) a vacuum chamber (14), which is connectable to an inert gas source (50) and a vacuum pump,
   b) a support device (20) for one or more substrates (12) which is inserted into or insertable into the vacuum chamber (14),

c) at least one graphite cathode (16) having an associated magnet arrangement forming a magnetron, the graphite cathode serving as a source of carbon material,

d) a bias power supply (32) for applying a negative bias voltage to the substrate or substrates on the support device (20),

e) at least one cathode power supply (18) for the or each cathode, which is connectable to the at least one graphite cathode (16) and to an associated anode and which is designed to transmit high power pulse sequences spaced at (preferably programmable) intervals of time

**characterized in that** the apparatus is adapted to manufacture carbon layers in the form of at least substantially hydrogen-free ta-C layers and **in that** the cathode power supply for the graphite cathode (16) is adapted to transmit high power pulse sequences each high power pulse comprising a series of high frequency DC pulses adapted to be supplied, optionally after a build-up phase, to the at least one graphite cathode (16) with the high frequency DC power pulses having a peak power in the range from 100 kW to over 2 megawatt, and a pulse repetition frequency in the range from 1Hz to 350 kHz, preferably in the range from 1 Hz to 2kHZ, especially in the range from 1Hz to 1.5 kHz and in particular of about 10 to 30Hz.

2. Apparatus (10) in accordance with claim 1 wherein the pulse pattern consists of controllable macro-pulses of a length in the range of 10 to 5000 μsec, typically in the range between 50 and 3000 μsec, and especially between 400 and 800 μsec.

3. Apparatus (10) in accordance with claim 1 or claim 2 wherein the macro-pulses consist of controllable micro-pulses in the range from 1 to 100 μsec, typically 5-50 μsec, with the power to the cathode being switched on and off during each micro-pulse, wherein the range for switching on is typically between 2 and 25 μsec and the range for the power to be switched off is typically between 6 and 1000 μsec.

4. Apparatus (10) in accordance with any one of the preceding claims,
**characterized in that**
the average power of the high power pulse sequences averaged over a longer period of time comprising a plurality of high power pulse sequences is comparable with the power of a DC sputtering system with a constant DC power in the range between 10 and 250 kW.

5. Apparatus (10) in accordance with any one of the preceding claims,
**characterized in that**
the average power of the high power pulse sequences is comparable with the power of a HIPIMS pulse power which lies, for example, in the range between 100 and 300 kW.

6. Apparatus (10) in accordance with any one of the preceding claims,
**characterized in that**
the apparatus comprises a plurality of magnetrons and associated cathodes, one of which comprises a bond layer material, the apparatus further comprising a power supply for the sputtering of bond layer material for the deposition of the bond layer material on the substrate or substrates prior to deposition of the ta-C layer.

7. Apparatus (10) in accordance with any one of the preceding claims,
**characterized in that**
the apparatus has at least one arc cathode of graphite and also an apparatus for the generation of an arc for the deposition of an arc carbon layer on the bond layer from the at least one magnetron cathode (16) of graphite.

8. Apparatus (10) in accordance with any one of the preceding claims,
**characterized in that**
the substrate or substrates (12) consist of one of the following materials: steel, especially 100 Cr6, titanium, titanium alloys, aluminium alloys and ceramic materials such as WC.

9. Apparatus (10) in accordance with any one of the preceding claims,
**characterized in that**
each high frequency pulse sequence called a macro-pulse consists of a plurality of micro pulses with initial micro-pulses defining an ignition phase and subsequent micro-pulses defining a high power phase, with the frequency of the micro-pulses in the ignition phase typically being higher than or comparable to that of the high power phase and the duration of the on-time of the micro-pulses in the ignition phase typically being shorter than that of the micro-pulses in the high power phase.

10. Apparatus (10) in accordance with any one of the preceding claims,
**characterized in that**
the high frequency power supply (80) contains a capacitor (82) that can be charged to supply the high frequency power pulses and also an LC oscillating circuit (92) which is connected between the capacitor (82) and the cathode or cathodes (16), the power supply preferably including an electronic switch (86) controllable by a program and adapted to connect the capacitor (82) to the at least one cathode (16) for the generation of the desired pulse sequence.

11. Apparatus (10) in accordance with claim 10,
**characterized in that**
the electronic switch (86) or an additional electronic switch (90) is adapted to connect the capacitor (82) after the build-up phase to the at least one cathode (16) via an LC circuit (92) to generate the high frequency DC power pulses.

12. Apparatus (10) in accordance with any one of the preceding claims,
**characterized in that**
the apparatus is adapted to carry out HIPIMS etching of the substrates.

13. A method of manufacturing a carbon layer on at least one substrate (12) (workpiece) of metal or ceramic materials, wherein the carbon layer is deposited in a vacuum chamber (14), which is connectable to an inert gas source (50) not containing hydrogen and to a vacuum pump by magnetron sputtering from at least one graphite cathode (16) having an associated magnetron and serving as a source of carbon material while using a bias power supply (32) for applying a bias to the at least one substrate (12) and a cathode power supply (18) which is connectable to the at least one graphite cathode (16) and to an associated anode and the method preferably being carried out at an Ar pressure of about 0,1 to 1,8 Pa ($1.10^{-3}$ to $8.10^{-2}$ mbar),
**characterized in that**
the carbon layer is an at least substantially hydrogen-free ta-C layer and **in that** each high power pulse comprises a series of high frequency DC pulses adapted to be supplied, optionally after a build-up phase, to the at least one graphite cathode (16) with the high frequency DC power pulses having a peak power in the range from 100 kW to over 2 megawatt, and a pulse repetition frequency in the range from 1Hz to 350 kHz, preferably in the range from 1 Hz to 2kHz, especially in the range from 1Hz to 1.5 kHz and in particular of about 10 to 30Hz.

14. A method in accordance with claim 13 and including the step of incorporating one or more doping elements such as metals in the coating and/or adding a small amount of hydrogen and/or $N_2$ to the coating.

15. A substrate (12) having a ta-C layer which is made by a method in accordance with one of the claims 13 or 14.


**Patentansprüche**

1. Vorrichtung (10) für die Herstellung von Kohlenstoffschichten auf Substraten aus Metall- oder Keramikmaterialien, wobei die Vorrichtung zumindest die folgenden Komponenten umfasst:

    a) eine Vakuumkammer (14), die mit einer Inertgasquelle (50) und einer Vakuumpumpe verbindbar ist,
    b) eine Trägervorrichtung (20) für ein oder mehrere Substrate (12), die in die Vakuumkammer (14) eingesetzt oder einsetzbar ist,
    c) zumindest eine Graphitkathode (16), die eine zugeordnete Magnetanordnung aufweist, die ein Magnetron bildet, wobei die Graphitkathode als eine Quelle für Kohlenstoffmaterial dient,
    d) eine Vorspannungsversorgung (32) zum Anlegen einer negativen Vorspannung an das Substrat oder die Substrate an der Trägervorrichtung (20),
    e) zumindest eine Kathodenleistungsversorgung (18) für die oder jede Kathode, die mit der zumindest einen Graphitkathode (16) und einer zugeordneten Anode verbindbar ist und die derart ausgelegt ist, Hochleistungspulssequenzen zu übertragen, die in (bevorzugt programmierbaren) Zeitintervallen beabstandet sind,

**dadurch gekennzeichnet, dass** die Vorrichtung derart angepasst ist, Kohlenstoffschichten in der Form zumindest im Wesentlichen wasserstofffreier ta-C-Schichten herzustellen, und dass die Kathodenleistungsversorgung für die Graphitkathode (16) derart angepasst ist, Hochleistungspulssequenzen zu übertragen, wobei jeder Hochleistungspuls eine Reihe hochfrequenter DC-Pulse umfasst, die derart ausgebildet sind, dass sie optional nach einer Aufbauphase an die zumindest eine Graphitkathode (16) geliefert werden, wobei die hochfrequenten DC-Leistungspulse eine Spitzenleistung im Bereich von 100 kW bis über 2 Megawatt sowie eine Pulswiederholfrequenz im Bereich von 1 Hz bis 350 kHz, bevorzugt im Bereich von 1 Hz bis 2 kHz, insbesondere im Bereich von 1 Hz bis 1,5 kHz und besonders von etwa 10 bis 30 Hz aufweisen.

2. Vorrichtung (10) nach Anspruch 1, wobei das Pulsmuster aus steuerbaren Makropulsen mit einer Länge im Bereich von 10 bis 5000 $\mu$s, typischerweise im Bereich von 50 bis 3000 $\mu$s und insbesondere zwischen 400 und 800 $\mu$s besteht.

3. Vorrichtung (10) nach einem der Ansprüche 1 oder 2, wobei die Makropulse aus steuerbaren Mikropulsen im Bereich von 1 bis 100 $\mu$s, typischerweise 5 bis 50 $\mu$s bestehen, wobei die Leistung zu der Kathode während jedes Mikropulses ein- und ausgeschaltet wird, wobei der Bereich zum Einschalten typischerweise zwischen 2 und 25 $\mu$s beträgt und der Bereich für die auszuschaltende Leistung typischerweise zwischen 6 und 1000 $\mu$s beträgt.

4. Vorrichtung (10) nach einem der vorhergehenden Ansprüche,
   **dadurch gekennzeichnet, dass**
   die durchschnittliche Leistung der Hochleistungspulssequenzen, die über eine längere Zeitperiode gemittelt sind, die eine Mehrzahl von Hochleistungspulssequenzen umfasst, mit der Leistung eines DC-Sputtersystems mit einer konstanten DC-Leistung im Bereich von 10 bis 250 kW vergleichbar ist.

5. Vorrichtung (10) nach einem der vorhergehenden Ansprüche,
   **dadurch gekennzeichnet, dass**
   die durchschnittliche Leistung der Hochleistungspulssequenzen mit der Leistung einer HIPIMS-Pulsleistung vergleichbar ist, die beispielsweise im Bereich zwischen 100 und 300 kW liegt.

6. Vorrichtung (10) nach einem der vorhergehenden Ansprüche,
   **dadurch gekennzeichnet, dass**
   die Vorrichtung eine Mehrzahl von Magnetrons sowie zugeordneten Kathoden umfasst, von denen eine ein Bindungsschichtmaterial umfasst, wobei die Vorrichtung ferner eine Leistungsversorgung für das Sputtern des Bindungsschichtmaterials zur Ablagerung des Bindungsschichtmaterials an dem Substrat oder den Substraten vor Abscheidung der ta-C-Schicht umfasst.

7. Vorrichtung (10) nach einem der vorhergehenden Ansprüche,
   **dadurch gekennzeichnet, dass**
   die Vorrichtung zumindest eine Bogenkathode aus Graphit sowie eine Vorrichtung für die Erzeugung eines Bogens für die Abscheidung einer Bogenkohlenstoffschicht an der Bindungsschicht von der zumindest einen Magnetronkathode (16) aus Graphit aufweist.

8. Vorrichtung (10) nach einem der vorhergehenden Ansprüche,
   **dadurch gekennzeichnet, dass**
   das Substrat oder die Substrate (12) aus einem der folgenden Materialien bestehen: Stahl, insbesondere 100 Cr6, Titan, Titanlegierungen, Aluminiumlegierungen sowie Keramikmaterialien, wie WC.

9. Vorrichtung (10) nach einem der vorhergehenden Ansprüche,
   **dadurch gekennzeichnet, dass**
   jede hochfrequente Pulssequenz, die auch als ein Makropuls bezeichnet ist, aus einer Mehrzahl von Mikropulsen mit anfänglichen Mikropulsen, die eine Zündphase definieren, und nachfolgenden Mikropulsen besteht, die eine Hochleistungsphase definieren, wobei die Frequenz der Mikropulse in der Zündphase typischerweise höher als oder vergleichbar mit der der Hochleistungsphase ist und die Dauer der Einschaltzeit der Mikropulse in der Zündphase typischerweise kürzer als diejenige der Mikropulse in der Hochleistungsphase ist.

10. Vorrichtung (10) nach einem der vorhergehenden Ansprüche,
    **dadurch gekennzeichnet, dass**
    die Hochfrequenzleistungsversorgung (80) einen Kondensator (82), der geladen sein kann, um die hochfrequenten Leistungspulse zu liefern, sowie auch einen LC-Schwingkreis (92) umfasst, der zwischen dem Kondensator (82) und der Kathode oder den Kathoden (16) geschaltet ist, wobei die Leistungsversorgung bevorzugt einen elektronischen Schalter (86) aufweist, der durch ein Programm steuerbar und derart angepasst ist, den Kondensator (82) mit der zumindest einen Kathode (16) für die Erzeugung der gewünschten Pulssequenz zu verbinden.

**11.** Vorrichtung (10) nach Anspruch 10,
**dadurch gekennzeichnet, dass**
der elektronische Schalter (86) oder ein zusätzlicher elektronischer Schalter (90) derart angepasst ist, den Kondensator (82) nach der Aufbauphase mit der zumindest einen Kathode (16) über einen LC-Schwingkreis (92) zu verbinden, um die hochfrequenten DC-Leistungspulse zu erzeugen.

**12.** Vorrichtung (10) nach einem der vorhergehenden Ansprüche,
**dadurch gekennzeichnet, dass**
die Vorrichtung derart angepasst ist, ein HIPIMS-Ätzen der Substrate auszuführen.

**13.** Verfahren zum Herstellen einer Kohlenstoffschicht an zumindest einem Substrat (12) (Werkstück) aus Metall- oder Keramikmaterialien,
wobei die Kohlenstoffschicht in einer Vakuumkammer (14), die mit einer Inertgasquelle (50), die keinen Wasserstoff enthält, und einer Vakuumpumpe verbindbar ist, durch Magnetronsputtern von zumindest einer Graphitkathode (16) abgeschieden wird, die einen zugeordneten Magnetron aufweist und als eine Quelle für Kohlenstoffmaterial dient, während eine Vorspannungsversorgung (32) zum Anlegen einer Vorspannung an das zumindest eine Substrat (12) und eine Kathodenleistungsversorgung (18) verwendet ist, die mit der zumindest einen Graphitkathode (16) und einer zugeordneten Anode verbindbar ist, wobei das Verfahren bevorzugt bei einem Ar-Druck von etwa 0,1 bis 1,8 Pa ($1,10^{-3}$ bis $8,10^{-2}$ mbar) ausführbar ist, **dadurch gekennzeichnet, dass**
die Kohlenstoffschicht eine zumindest im Wesentlichen wasserstofffreie ta-C-Schicht ist und dass jeder Hochleistungspuls eine Reihe hochfrequenter DC-Pulsen umfasst, die zur Lieferung optional nach einer Aufbauphase an die zumindest eine Graphitkathode (16) angepasst sind, wobei die hochfrequenten DC-Leistungspulse eine Spitzenleistung im Bereich von 100 kW bis über 2 Megawatt und eine Pulswiederholfrequenz im Bereich von 1 Hz bis 350 kHz, bevorzugt im Bereich von 1 Hz bis 2 kHz, besonders im Bereich von 1 Hz bis 1,5 kHz und insbesondere von etwa 10 bis 30 Hz aufweisen.

**14.** Verfahren nach Anspruch 13, mit dem Schritt zum Einschluss eines oder mehrerer Dotierelemente, wie Metallen in der Beschichtung und/oder Zusatz einer kleinen Menge an Wasserstoff und/oder $N_2$ zu der Beschichtung.

**15.** Substrat (12) mit einer ta-C-Schicht, die durch ein Verfahren nach einem der Ansprüche 13 oder 14 ausgebildet ist.

## Revendications

**1.** Appareil (10) pour la réalisation de couches de carbone sur les substrats de matériaux métalliques ou céramiques, dans lequel l'appareil inclut au moins les composants suivants :

a) une chambre sous vide (14), qui peut être connectée à une source de gaz inerte (50) et à une pompe à vide,
b) un dispositif de support (20) pour un ou plusieurs substrats (12), qui est inséré ou susceptible d'être inséré dans la chambre sous vide (14),
c) au moins une cathode de graphite (16) ayant un agencement magnétique associé formant un magnétron, la cathode de graphite servant de source de matériau de carbone,
d) une alimentation de puissance de polarisation (32) pour appliquer une tension de polarisation négative sur le substrat ou les substrats sur le dispositif de support (20),
e) au moins une alimentation de puissance de cathode (18) pour la ou pour chaque cathode, qui est susceptible d'être connectée à ladite au moins une cathode de graphite (16) et à une anode associée, et qui est conçue pour transmettre des séquences d'impulsions de haute puissance espacées à des intervalles temporels (de préférence programmables),

**caractérisé en ce que** l'appareil est adapté à la réalisation de couches de carbone sous la forme de couches de ta-C au moins sensiblement dépourvues d'hydrogène et **en ce que** l'alimentation de puissance de cathode pour la cathode de graphite (16) est adaptée pour transmettre des séquences d'impulsions de haute puissance, chaque impulsion de haute puissance comprenant une série d'impulsions DC de haute fréquence, adaptées à être alimentées, en option après une phase de démarrage, à ladite au moins une cathode de graphite (16), les impulsions de puissance DC de haute fréquence ayant une puissance de pointe dans la plage de 100 kW jusqu'à plus de 2 MW, et une fréquence de répétition d'impulsions dans la plage de 1 Hz à 350 kHz, de préférence dans la plage de 1 Hz à 2 kHz, spécialement dans la plage de 1 Hz à 1,5 kHz, et en particulier d'environ 10 à 30 Hz.

2. Appareil (10) selon la revendication 1, dans lequel le motif d'impulsions est constitué de macro-impulsions susceptibles d'être commandées, avec une longueur dans la plage de 10 à 5000 μs, typiquement dans la plage entre 50 et 3000 μs, et spécialement entre 400 et 800 μs.

3. Appareil (10) selon la revendication 1 ou 2, dans lequel les macro-impulsions sont constituées de micro-impulsions susceptibles d'être commandées dans la plage de 1 à 500 μs, typiquement 5 à 50 μs, la puissance à la cathode étant commutée EN et HORS pendant chaque micro-impulsion, et la plage pour la commutation EN est typiquement entre 2 et 25 μs, et la plage pour la commutation HORS est typiquement entre 6 et 1000 μs.

4. Appareil (10) selon l'une quelconque des revendications précédentes, **caractérisé en ce que** la puissance moyenne des séquences d'impulsion de haute puissance, moyennée sur une période temporelle plus longue comprenant une pluralité de séquences d'impulsions de haute puissance, est comparable avec la puissance d'un système de pulvérisation à courant continu avec une puissance en courant continue constante dans la plage entre 10 et 250 kilowatts.

5. Appareil (10) selon l'une quelconque des revendications précédentes, **caractérisé en ce que** la puissance moyenne des séquences d'impulsion de haute puissance est comparable à la puissance d'une impulsion HIPIMS qui est située, par exemple, dans la plage entre 100 et 300 kW.

6. Appareil (10) selon l'une quelconque des revendications précédentes, **caractérisé en ce que** l'appareil comprend une pluralité de magnétrons et de cathodes associées, l'une d'entre elles comprenant un matériau de couche de bonding, l'appareil comprenant en outre une alimentation de puissance pour la pulvérisation du matériau de couche de bonding, destinée à la déposition du matériau de couche de bonding sur le substrat ou les substrats avant déposition de la couche de ta-C.

7. Appareil (10) selon l'une quelconque des revendications précédentes, **caractérisé en ce que** l'appareil comprend au moins une cathode d'arc en graphite et également un appareil pour la génération d'un arc pour la déposition d'une couche de carbone à l'arc sur la couche de bonding depuis ladite au moins une cathode de magnétron (16) en graphite.

8. Appareil (10) selon l'une quelconque des revendications précédentes, **caractérisé en ce que** le substrat ou les substrats (12) est/sont constitué(s) de l'un des matériaux suivants :
acier, spécialement 100 Cr6, titane, alliages de titane, alliages d'aluminium et matériaux céramiques, comme WC.

9. Appareil (10) selon l'une quelconque des revendications précédentes, **caractérisé en ce que** chaque séquence d'impulsions de haute fréquence, appelée macro-impulsion, est constituée d'une pluralité de micro-impulsions avec des micro-impulsions initiales définissant une phase d'allumage et des micro-impulsions ultérieures définissant une phase à haute puissance, la fréquence des micro-impulsions dans la phase d'allumage étant typiquement plus élevée que ou comparable à celle de la phase à haute puissance, et la durée du temps EN des micro-impulsions dans la phase d'allumage étant typiquement plus courte que celle des micro-impulsions dans la phase à haute puissance.

10. Appareil (10) selon l'une quelconque des revendications précédentes, **caractérisé en ce que** l'alimentation de puissance à haute fréquence (80) contient un condensateur (82) qui peut être chargé pour alimenter les impulsions de puissance à haute fréquence et également un circuit oscillant LC (92) qui est connecté entre le condensateur (82) et la cathode ou les cathodes (16), l'alimentation de puissance incluant de préférence un commutateur électronique (86) susceptible d'être commandé par un programme et adapté pour connecter le condensateur (82) à ladite au moins une cathode (16) pour la génération de la séquence d'impulsions désirée.

11. Appareil (10) selon la revendication 10,
**caractérisé en ce que** le commutateur électronique (86) ou un commutateur électronique additionnel (90) est adapté pour connecter le condensateur (82) après la phase de démarrage à ladite au moins une cathode (16) via un circuit LC (92) pour générer les impulsions de puissance DC de haute fréquence.

12. Appareil (10) selon l'une quelconque des revendications précédentes, **caractérisé en ce que** l'appareil est adapté pour effectuer une attaque HIPIMS sur les substrats.

**13.** Procédé pour la réalisation d'une couche de carbone sur au moins un substrat (12) (pièce à oeuvrer) de matériaux métalliques ou céramiques, dans lequel la couche de carbone est déposée dans une chambre sous vide (14), qui peut être connectée à une source de gaz inerte (50) qui ne contient pas d'hydrogène et à une pompe à vide, par pulvérisation à magnétron depuis au moins une cathode de graphite (16) ayant un magnétron associé et servant de source de matériau de carbone tout en utilisant une alimentation de puissance de polarisation (32) pour appliquer une polarisation audit au moins un substrat (12), et une alimentation de puissance de cathode (18) qui peut être connectée à ladite au moins une cathode de graphite (16) et à une anode associée, et le procédé étant de préférence mis en oeuvre à une pression de Ar d'environ 0,1 à 1,8 Pa (1.10$^{-3}$ à 8.10$^{-2}$ mbar),
**caractérisé en ce que**
la couche de carbone est une couche de ta-C sensiblement dépourvue d'hydrogène, et **en ce que** chaque impulsion de haute puissance comprend une série d'impulsions DC de haute fréquence adaptées à être alimentées, en option après une phase de démarrage, à ladite au moins une cathode de graphite (16), les impulsions de puissance DC de haute fréquence ayant une puissance de pointe dans la plage de 100 kW jusqu'à plus de 2 MW, et une fréquence de répétition d'impulsion dans la plage de 1 Hz à 350 Hz, de préférence dans la plage de 1 Hz à 2 kHz, spécialement dans la plage de 1 Hz à 1,5 kHz, et en particulier d'environ 10 à 30 Hz.

**14.** Procédé selon la revendication 13, incluant l'étape consistant à incorporer un ou plusieurs éléments dopants, tels que des métaux, dans le revêtement et/ou à ajouter une petite quantité d'hydrogène et/ou de N$_2$ au revêtement.

**15.** Substrat (12) ayant une couche de ta-C qui est réalisée par un procédé en accord avec l'une des revendications 13 ou 14.

Fig. 1

FIG 2

FIG. 3

PULSE FILE 35

FIG 4A

PULSE ALE 42

FIG 43

FIG 4C

FIG: 5A

FIG: 5B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- DE 202010001497 U1
- EP 1652966 A2
- EP 07724122 A
- WO 2007115819 A
- EP 1260603 B

### Non-patent literature cited in the description

- **R. TIETEMA ; D. DOERWALD ; R. JACOBS ; T. KRUG.** Diamond-like Carbon Coatings for tribological applications on Automotive Components. *4th World Tribology Congress,* September 2009
- Ultralow friction of DLC in presence of glycerol mono-oleate (GMO). *Tribology Letters,* 2005, vol. 18 (2), 245
- **X. JUNQI.** Hydrogen-free carbon thin films prepared by unbalanced magnetron sputtering. *proceedings of SPIE,* 2006, vol. 6149, 61492S-61492S, 5
- **J. LIN.** Modulated pulse power sputtered chromium coatings. *Thin Solid Films,* 2009, vol. 518, 1566-1570
- **B. M. DEKOVENET.** Carbon Thin Film Deposition Using High Power Pulsed Magnetron Sputtering. *SVC 46th Annual Conference Proceedings,* 2003, 158-165